# EUROPEAN PATENT APPLICATION

(11) **EP 4 421 919 A1**
(43) Date of publication of application: **28.08.2024**
(21) Application number: 22885309.9
(22) Date of filing: 12.08.2022
(51) Int. Cl.: H01M 4/62, H01M 4/505, H01M 4/525, H01M 10/0525

(54) **SINGLE-CRYSTAL TERNARY POSITIVE ELECTRODE MATERIAL, PREPARATION METHOD THEREFOR, AND APPLICATION THEREOF**

(30) Priority: 29.10.2021 CN 202111276497
(71) Applicant: Guangdong Brunp Recycling Technology Co., Ltd., Foshan, Guangdong 528137 (CN); Hunan Brunp Recycling Technology Co., Ltd., Changsha, Hunan 410600 (CN); Hunan Brunp EV Recycling Co., Ltd., Changsha, Hunan 410600 (CN)
(72) Inventor: ZHU, Qinglin, Foshan, Guangdong 528137 (CN); LI, Changdong, Foshan, Guangdong 528137 (CN); RUAN, Dingshan, Foshan, Guangdong 528137 (CN); CAI, Yong, Foshan, Guangdong 528137 (CN); LIU, Weijian, Foshan, Guangdong 528137 (CN)
(74) Representative: Primiceri, Maria Vittoria
(86) International application number: PCT/CN2022/112237
(87) International publication number: WO 2023/071409

(57) **Abstract**

The present invention relates to the technical field of lithium-ion batteries. Disclosed are a single-crystal ternary positive electrode material, a preparation method therefor, and an application thereof. The chemical formula of the single-crystal ternary positive electrode material is LiNiₓCo_{y}Mn_{z}M_{(1-x-y-z)}O_{c}@LiₐN_{d}O_{b}, 0<x≤0.65, 0<y≤0.15, 0<z≤0.35, 0<a≤6, 0<b≤4, 1<c ≤2, and 1≤d< 2; and M and N are each at least one of Zr, Ni, Al, Cu, Co, Sr, Mn, Y, Ti, Mg, Mo, B, Sn, Fe, Zn, Si, or W. The single-crystal ternary positive electrode material of the present invention is a single-crystal material having a core-shell structure, and has less residual lithium on the surface, stable internal and external structures, high energy density and excellent cycle performance and dynamics performance.

## Description

### TECHNICAL FIELD

The present invention belongs to the technical field of lithium ion batteries. More particularly, it relates to a single-crystal ternary cathode material, a preparation method therefor and use thereof.

### BACKGROUND

A ternary cathode material has been always received attentions in new energy industry due to its high specific capacity, high specific energy density, excellent cycling performance, safety, low cost and so forth. In general, in order to gain a higher capacity, research and development of the ternary material is mainly divided into two directions as follows. A first direction is to increase the nickel content and prepare a high-nickel material. However, Li has a radius similar to that of Ni, so exchanging of Ni and Li leads to disordering of lithium and nickel. The greater the concentration of nickel ions in a lithium layer is, the more difficult the deintercalation and intercalation of the lithium in the stratified structure is, the poorer the stability of the material is, the poorer the safety is, and the higher the cost is. A second direction is to increase charging and discharging voltages of the material and allow the lithium in the lattice of the ternary material to be released and inserted to a greater extent, but it will lead to several problems, including the unstable structure of the material, the aggravation of surface side reaction between the cathode material and an electrolytic solution under a high voltage, the consumption of lattice lithium and hindering transmission of the lithium, which deteriorates cycling performance of the material and results in serious gas production.

Currently, the problems of cycling performance of the material and gas production under the high voltage are solved mainly by improving the stability of substrate of the material, reducing the surface area of the material, and isolating the direct contact between the material and the electrolytic solution, etc. The treatment mode is mainly to improve the safety and the stability of the material itself by doping. It is mainly to support the structure of the stratified material when more lithium is released. Doping includes doping of zirconium, titanium, aluminum, tungsten, magnesium, scandium, vanadium, calcium, strontium, barium, gallium, indium and other elements. By coating a stable coating layer and increasing the size of single-crystal particles, contact reaction between the material and the electrolytic solution and metal dissolution effect are reduced, and thus problems of gas production, cycling and the like of a cell are reduced. Generally, metal oxides (Al₂O₃, TiO₂, ZnO, ZrO₂ and the like) for coating modify the surfaces of ternary materials. However, under the high voltage, in order to maintain the stable structure of the material, the content of doping elements is a bit high, which makes the material structure stable, but the capacity of the material is a bit low. The coating and large particles of the material can increase DCR of the material. Especially, under the condition that a discharging potential is relatively low, lithium ions in the electrolytic solution difficultly enter a lattice of the cathode material, resulting in a bit low capacity and poorer cycling of the material.

### SUMMARY

The present invention aims to solving at least one of technical problems existing in the prior art. In view of this, the present invention provides a single-crystal ternary cathode material and a preparation method therefor and use thereof. The single-crystal ternary cathode material is stable in structure, high in capacity and excellent in cycle performance and dynamic performance.

In order to solve the above objective, the present invention adopts the following technical solution.

Provided is a single-crystal ternary cathode material, wherein the chemical formula of the single-crystal ternary cathode material is LiNiₓCo_{y}Mn_{z}M_{(1-x-y-z)}O_{c}@LiₐN_{d}O_{b}, 0<x≤0.65, 0<y≤0.15, 0<z≤0.35, 0<a≤6, 0<b≤4, 1<c≤2 and 1≤d<2; M is at least one of Zr, Ni, Al, Cu, Co, Sr, Mn, Y, Ti, Mg, Mo, B, Sn, Fe, Zn, Si and W; and N is at least one of Zr, Ni, Al, Cu, Co, Sr, Mn, Y, Ti, Mg, Mo, B, Sn, Fe, Zn, Si and W.

Preferably, the chemical formula of the single-crystal ternary cathode material is LiNi_{0.596}Co_{0.05}Mn_{0.35}M_{0.004}O_{c}@Li₂N_{d}O₄; M is at least one of Zr, Zn, Si and W; and N is at least one of Zr, Al, Mo, Zn, Si and W, wherein x=0.596, y=0.05, z=0.35, a=2, b=4, 1<c≤2 and 1≤d<2.

Further preferably, M is Zr and W.

Further preferably, N is Zr, Al and W.

Preferably, the single-crystal ternary cathode material has a particle size of 1.0-5.0 µm and a specific surface area of 0.4-0.8 m²/g.

Provided is a preparation method for a single-crystal ternary cathode material, comprising the following steps:
(1) mixing a nickel salt, a manganese salt and a cobalt salt, adding a precipitator and a complexing agent, conducting reaction and solid-liquid separation, and taking a solid phase to obtain a precursor;
(2) mixing the precursor with a lithium source and a first doping agent for first sintering, and conducting crushing to obtain a single-crystal material; and
(3) mixing the single-crystal material with a second doping agent for second sintering, adding a coating agent for mixing, and conducting third sintering to obtain a single-crystal cathode material.

The above single-crystal ternary cathode material is a ternary cathode material which is stable in structure, high in energy density and excellent in cycle performance and dynamic performance under a high voltage. The stability of an internal structure is improved by doping a lattice of single crystal, and then the surface doping in gradient of the single-crystal material is conducted at a high temperature to construct a single-crystal material with a stable structure from the inside to the surface and no fine powder, and finally coating and tempering at a low temperature are conducted so as to form a coating layer and a fast ion conductive layer that have a low residual lithium content on the surface and can supplement the loss of a lithium source during battery cycles. A fast ion conductive network is formed in lattice doping, surface doping in gradient of the material, less fine powder, a lithium supplement agent and the crystal surface, and the electrochemical performance of the cathode material under the high voltage is improved under the combined action of these several strategies.

Preferably, in the step (1), the nickel salt is at least one of nickel sulfate, nickel chloride and nickel nitrate.

Preferably, in the step (1), the manganese salt is at least one of manganese sulfate, manganese chloride and manganese nitrate.

Preferably, in the step (1), the cobalt salt is at least one of cobalt sulfate, cobalt chloride and cobalt nitrate.

Preferably, in the step (1), the precipitating agent is sodium hydroxide.

Preferably, in the step (1), the complexing agent is ammonium hydroxide.

Preferably, in the step (1), a reaction temperature is 60-90°C, and a reaction time is 70-75 h. Preferably, in the step (1), during reaction, a pH value is maintained to be 9.5-12.0.

Preferably, the step (1) also comprises: drying a solid phase after solid-liquid separation, wherein a drying temperature is 100-125°C, and a drying time is 24-30 h.

Preferably, in the step (1), the particle size distribution D50 of the precursor is 3.8-4.5 µm. Preferably, in the step (1), during reaction, a stirring speed is 500-600 r/min.

Preferably, in the step (2), the lithium source is at least one of LiOH, Li₂CO₃, LiNO₃ and CH₃COOLi.

Preferably, in the step (2), a molar ratio of lithium in the lithium source to metal elements in the precursor is 1: (1.06-1.25).

Preferably, in the step (2), the first doping agent is an oxide of at least one of the following doping elements: Zr, Ni, Al, Cu, Co, Sr, Mn, Y, Ti, Mg, Mo, B, Sn, Fe, Zn, Si and W; and the total content of the doping elements is 300-5000 ppm.

Further preferably, the first doping agent is at least one of ZrO₂, NiO, Al₂O₃, CuO, CoO, Co₃O₄, SrO, MnO₂, Y₂O₃, TiO₂, MgO, MoO₂, B₂O₃, SnO₂, Fe₂O₃, ZnO, SiO₂ and WO₃.

Preferably, in the step (2), a rotation speed for the mixing is 300-500 r/min, and a mixing time is 0.5-1.5 h.

Preferably, in the step (2), the process of first sintering is performed as follows: air/oxygen having the intensity of pressure of 0.15-0.5 MPa is introduced, a temperature is raised to 450-800°C at a heating rate of 0.5-5.0°C/min for pre sintering for 3-8 h, and continued to be increased to 850-950°C for sintering at the same heating rate and preserved for 8-15 h, and natural cooling is conducted to room temperature to obtain the single-crystal ternary cathode material.

After first sintering, a multi-crystal particulate material with elements doped in the lattices and more residual lithium present between the lattices is obtained.

Preferably, in the step (2), the process of crushing is as follows: crushing is conducted by rotary wheel mill and jet mill in sequence. Further, the rotary wheel mill is used for crushing a material to be crushed to a particle size of 1-2 mm.

Preferably, in the step (3), the second doping agent is an oxide of at least one of the following doping elements: Zr, Ni, Al, Cu, Co, Sr, Mn, Y, Ti, Mg, Mo, B, Sn, Fe, Zn, Si and W; and the total content of the doping elements is 1000-10000 ppm.

Further preferably, the second doping agent is at least one of ZrO₂, NiO, Al₂O₃, CuO, CoO, Co₃O₄, SrO, MnO₂, Y₂O₃, TiO₂, MgO, MoO₂, B₂O₃, SnO₂, Fe₂O₃, ZnO, SiO₂ and WO₃.

After second sintering, surface doping in gradient is formed on the surface of the single crystal.

Preferably, in the step (3), the process of second sintering is performed as follows: air/oxygen having the intensity of pressure of 0.15-0.5 MPa is introduced, the temperature is raised to 650-950°C at a heating rate of 0.5-5.0°C/min for pre sintering for 3-8 h, and natural cooling is conducted to room temperature.

Preferably, in the step (3), the coating agent is an oxide of at least one of the following coating elements: Zr, Ni, Al, Cu, Co, Sr, Mn, Y, Ti, Mg, Mo, B, Sn, Fe, Zn, Si and W; and the total content of the coating elements is 1000-5000 ppm.

Further preferably, the coating agent is at least one of ZrO₂, NiO, Al₂O₃, CuO, CoO, Co₃O₄, SrO, MnO₂, Y₂O₃, TiO₂, MgO, MoO₂, B₂O₃, SnO₂, Fe₂O₃, ZnO, SiO₂ and WO₃.

Preferably, in the step (3), the process of third sintering is performed as follows: air/oxygen having the intensity of pressure of 0.15-0.5 MPa is introduced, the temperature is raised to 450-650°C at a heating rate of 0.5-5.0°C/min for pre sintering for 1-6 h, and natural cooling is conducted to room temperature.

Provided is a battery, comprising the single-crystal ternary cathode material.

Compared with the prior art, the present invention has the beneficial effects:
1. The single-crystal ternary cathode material LiNiₓCo_{y}Mn_{z}M_{(1-x-y-z)}O₂@LiₐNO_{b} of the present invention is a single-crystal material of a core-shell structure and is low in surface lithium residue, stable in internal and external structure, high in energy density and excellent in cycle performance and dynamic performance; and a fast ion conductor is formed by doping, and then surface doping in gradient and coating are conducted so as to form a coating layer and a fast ion conductive layer which are less in surface residual lithium content and can supplement loss of the lithium source in the process of battery cycle, and thus the electrochemical performance of cathode materials under the high voltage is improved.
2. Through first sintering, the lithium source reacts with the first doping agent to form the fast ion conductor, thereby improving an electron and ion transmission channel of the material, reducing the local overpotential to affect the structural stability of the material, and meanwhile improving the ion and electron transmission dynamic performance of the material. Through second sintering, surface doping in gradient (a coating layer of a stable structure) is formed on the surface of the single crystal, and the crystal structure of the coating layer is close to the internal structure, so that even if the thickness of the prepared shell is very small, the surface layer of the material does not fall off because of volume expansion or shrinkage in the processes of charging and discharging, and the surface of the single crystal is stabilized. In addition, high temperature can also allow micro powders generated in the process of crushing for a single-crystal sample to react with the lithium source remained on the surface to form the cathode material, thereby reducing BET and residual lithium of the material, decreasing the side reaction on the surface of the material in battery, improving the cycle performance and gas production performance of the battery and increasing the impedance.
3. In the process of third sintering, the lithium source remained on the surface of the single-crystal material reacts with some elements (elements of the coating agent) to form a lithium supplement agent to supplement loss of lattice lithium in the processes of charging and discharging, especially in the case of deep deintercalation of lithium caused by high voltage, and the excess residual lithium on the surface of the material is transformed into a favorable lithium supplement agent or a fast ion channel, so that the cycle performance and the rate performance of the single-crystal material in the battery may be obviously improved.
4. In the process of preparing the single-crystal material, disordering of the lithium and nickel elements in the material is reduced by increasing the molar ratio of the lithium to the metal element in the precursor so as to obtain the single-crystal ternary material of an integral internal structure. In addition, doping other elements into the lattice can stabilize the crystal structure inside the material, a high molar ratio of the lithium to metal element in the precursor can result in an unreacted lithium source, which becomes the favorable fast ion conductor and the lithium supplement agent so as to improve the rate performance and the cycle performance of the material. Moreover, the stable shell-core structure allows the inside and the surface of the material to form the stable structure on the basis of ensuring the capacity, thereby improving the BET (specific surface area) and residual lithium of the material, reducing occurrence of interface side reaction between the material and the electrolytic solution in the material and then improving the cycle performance and the gas production performance.

### BRIEF DESCRIPTION OF DRAWINGS

Fig. 1 shows X-Ray diffraction (XRD) graphs of phases of single-crystal cathode materials prepared in Example 1 and Comparative Example 1;
Fig. 2 shows a scanning electron microscope (SEM) graph of a phase of a single-crystal cathode material prepared in Example 1;
Fig. 3 shows SEM graph of a cathode material prepared in Comparative Example 2;
Fig. 4 shows SEM graph of a cathode material prepared in Comparative Example 3; and
Fig. 5 shows cycle performance graph of single-crystal ternary cathode materials prepared in Example 1, Comparative Example 1, Comparative Example 2 and Comparative Example 3.

### DETAILED DESCRIPTION

The concept and generated technical effects of the present invention will be clearly and completely described in combination with examples to sufficiently understand the objective, features and effects of the present invention. Obviously, the described examples are only a part of examples of the present invention but not all the examples. Based on the examples of the present invention, other examples obtained by those skilled in the art without creative efforts are all included within the protective scope of the present invention.

### Example 1

A single-crystal ternary cathode material in this example has chemical formula of LiNi_{0.596}Co_{0.05}Mn_{0.35}M_{0.004}O₂@Li₂NO₄, wherein M is Zr and W; N is Zr, Al and W; and the single crystal has an average particle size of 1.5-3 µm and a specific surface area of 0.4-0.8 cm²/g.

A preparation method for the single-crystal ternary cathode material in this example specifically comprised the following steps:
(1) NiSO₄, CoSO₄ and MnSO₄ were prepared into a mixed solution having a total metal ion concentration of 1.6mol/L in a molar ratio of Ni: Co: Mn of 0.60: 0.05: 0.35, and 10 mol/L NaOH solution was then prepared;
(2) the mixed solution was introduced into a reaction kettle, the NaOH solution and an ammonia aqueous solution were introduced into the reaction kettle, the above materials were stirred and reacted for 70 h with a reaction temperature adjusted to 70°C and at a stirring speed of 500 r/min, a pH value in the reaction kettle was maintained to be 9.5-12.0, and a reaction product was filtered, washed with water and then dried for 24 h in vacuum at 120°C so as to obtain a flaky porous precursor with particle size distribution D50=3.8-4.5 µm;
(3) 3 kg of the precursor was mixed with lithium carbonate, ZrO₂ and WO₃ (a metal molar ratio of lithium in lithium carbonate to the precursor was 1.15, and a total content of Zr and W was 4000 ppm), and the obtained mixture was subjected to first sintering under the air condition of 0.2 MPa, was heated to 750°C at a heating rate of 3°C/min, was subjected to thermal preservation for 5 h, continued to be heated to 950°C for sintering, then was subjected to thermal preservation for 12 h and was cooled to room temperature with a furnace, then a product was crushed and screened via a 300-mesh sieve to obtain a single-crystal ternary cathode material with a low lithium-nickel disordering degree and a stable structure;
(4) the crushed single-crystal ternary cathode material was mixed with ZrO₂ (the content of Zr was 2000 ppm), and an obtained mixture was subjected to second sintering under the air condition of 0.2 MPa, was heated from room temperature to 750°C at a heating rate of 3°C/min, was subjected to thermal preservation for 4 h and then was cooled to room temperature to obtain a single-crystal material with a surface doped with metal in gradient; and
(5) the single-crystal material subjected to second sintering was mixed with Al₂O₃ and WO₃ (a total content of Al and W was 4000 ppm), an obtained mixture was subjected to third sintering under the air condition of 0.2 MPa, was heated to 450°C at a heating rate of 3°C/min, was subjected to thermal preservation for 5 h and then was cooled to room temperature to obtain the single-crystal ternary cathode material.

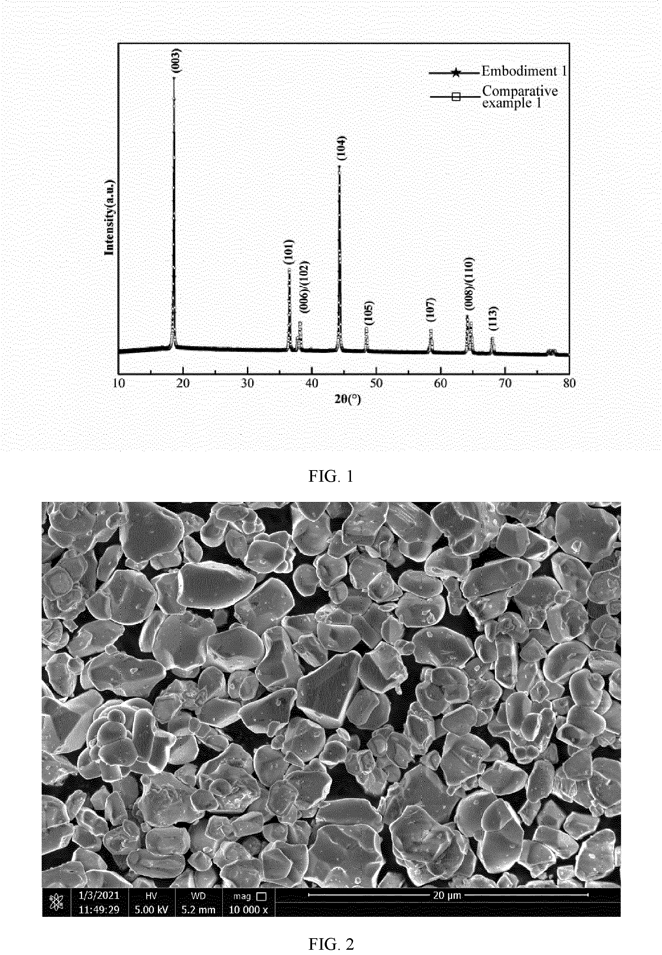

XRD analysis of a phase of the single-crystal ternary cathode material in this example is shown in Fig. 1, and its morphology is shown in Fig. 2. From Fig. 2, after third sintering, a uniform coating layer is formed on the surface of the single crystal.

Through the above steps, a ternary single-crystal cathode material with a stable structure, relatively high capacity and excellent cyclic performance and dynamic performance under the condition of high voltage is obtained.

The cathode material, a conductive agent SP and a binder PVDF were mixed in a ratio of 8: 1: 1 (with a total mass of 20 g), and then added in 20 g of NMP organic solvent to obtain a mixed solution. The mixed solution was stirred to obtain slurry, 8 µm aluminum foil was coated with the slurry at a thickness of 200 µ m evenly and was dried in a drying oven at 120° C under vacuum for 4 h, a dried electrode sheet was compacted on a 30T roller press and finally cut into a circular cathode sheet with a diameter of 14 mm. The mass of an active material in the circular sheet was about 15.00 g. The cut cathode sheet, an electrolytic solution and a diaphragm were assembled into a button type battery. After still standing, the electrochemical performance of the battery was tested, and the reference current density was tested, namely, 1 C = 190 mA/g.

### Example 2

A single-crystal ternary cathode material in this example has a chemical formula of LiNi_{0.799}Co_{0.1}Mn_{0.1}M_{0.001}O₂@Li₂NO₄, wherein M is Zr and W; N is Zr, Al and W; and the single crystal has an average particle size of 1.5-3 µm and a specific surface area of 0.4-0.8 cm²/g.

A preparation method for the single-crystal ternary cathode material specifically comprised the following steps:
(1) NiSO₄, CoSO₄ and MnSO₄ were prepared into a mixed solution having a total metal ion concentration of 1.6 mol/L in a molar ratio of Ni: Co: Mn of 0.80: 0.10: 0.10, and 10 mol/L NaOH solution was then prepared;
(2) the mixed solution was introduced into a reaction kettle, the NaOH solution and an ammonia aqueous solution were introduced into the reaction kettle, the above materials were stirred and reacted for 70 h with a reaction temperature adjusted to 70°C and at a stirring speed of 500 r/min, and a pH value in the reaction kettle was maintained to be 10, a reaction product was filtered, washed with water and then dried for 24 h in vacuum at 120°C so as to obtain a flaky porous precursor with particle size distribution D50=3.8-4.5 µm;
(3) 3 kg of the precursor was mixed with lithium carbonate, ZrO₂ and WO₃ (a metal molar ratio of lithium in the lithium carbonate to the precursor was 1.15, and a total content of Zr and W was 4000 ppm), an obtained mixture was subjected to first sintering under the air condition of 0.2 MPa, was heated to 750°C at a heating rate of 3°C/min, was subjected to thermal preservation for 5 h, continued to be heated to 950°C for sintering, then was subjected to thermal preservation for 12 h and was cooled to a room temperature with a furnace, and then a product was crushed and screened via a 300-mesh sieve to obtain a single-crystal ternary cathode material with a low lithium-nickel disordering degree and a stable structure;
(4) the crushed single-crystal ternary cathode material was mixed with ZrO₂ (the content of Zr was 2000 ppm), and an obtained mixture was subjected to second sintering under the air condition of 0.2 MPa, was heated from room temperature to 750°C at a heating rate of 3°C/min, was subjected to thermal preservation for 4 h and then was cooled to room temperature to obtain a single-crystal material with a surface doped with metal in gradient; and
(5) the single-crystal material subjected to second sintering was mixed with Al₂O₃ and WO₃ (a total content of Al and W was 4000 ppm), the obtained mixture was subjected to third sintering under the air condition of 0.2 MPa, was heated to 450°C at a heating rate of 3°C/min, was subjected to thermal preservation for 5 h and then was cooled to room temperature to obtain the single-crystal ternary cathode material.

Through the above steps, the ternary single-crystal cathode material with a stable structure, relatively high capacity and excellent cyclic performance and dynamic performance under the condition of high voltage is obtained.

The cathode material, a conductive agent SP and a binder PVDF were mixed in a ratio of 8: 1: 1 (a total mass: 20 g), and then added in 20 g of NMP organic solvent to obtain a mixed solution. The mixed solution was stirred to obtain slurry, an 8 µm aluminum foil was coated with the slurry at a thickness of 200 µm evenly and dried in a drying oven under vacuum at 120° C under vacuum for 4 h, a dried electrode sheet was compacted on a 30T roller press and finally cut into a circular cathode sheet with a diameter of 14 mm. The mass of an active material in the circular sheet was about 15.00 g. The cut cathode sheet, an electrolytic solution and a diaphragm were assembled into a button type battery. After still standing, the electrochemical performance of the battery was tested, and the reference current density was tested, namely, 1 C = 190 mA/g.

### Comparative Example 1

A preparation method for a single-crystal ternary cathode material in this comparative example specifically comprised the following steps: the steps in Comparative Example 1 were nearly the same as those in Example 1, except that the lithium proportion in the step (3) of Example 1 was changed to 1.05.

The XRD graph of the cathode material obtained by the method in Comparative Example 1 is as shown in Fig. 1.

### Comparative Example 2

A preparation method for a single-crystal ternary cathode material in this comparative example specifically comprised the following steps: preparation of a material in Comparative Example 2 was nearly the same as that in Example 1, except that the step (4) of Example 1 was omitted.

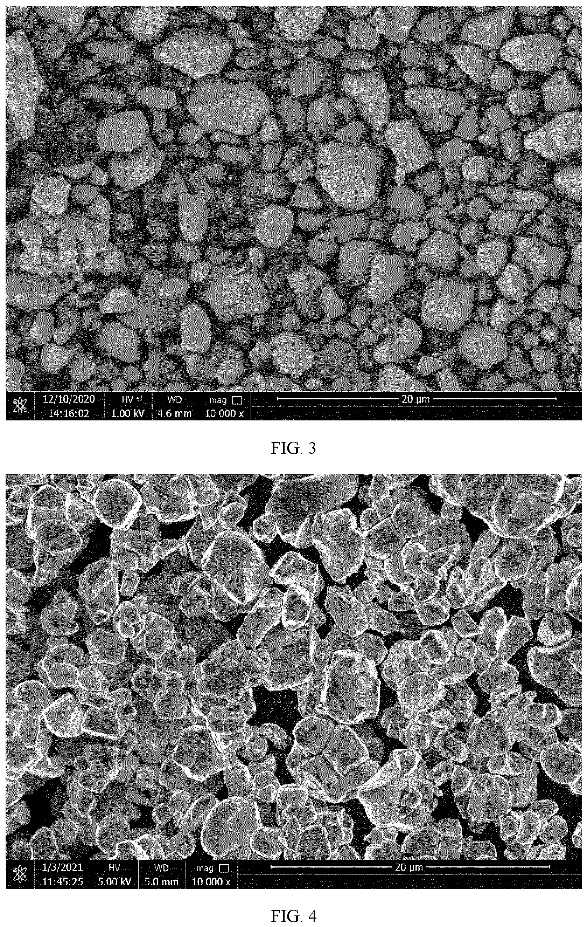

The morphology of the cathode material obtained by the method in Comparative Example 2 is as shown in Fig. 3.

### Comparative Example 3

A preparation method for a single-crystal ternary cathode material in this comparative example specifically comprised the following steps: preparation of a material in Comparative Example 3 was nearly the same as that in Example 1, except that the step (5) of Example 1 was omitted.

The XRD graph of the cathode material obtained by the method in Comparative Example 3 is as shown in Fig. 4.

### Comparative Example 4

A preparation method of a single-crystal ternary cathode material in this comparative example specifically comprised the following steps: ZrO₂, Al₂O₃ and WO₃ in steps (4) and (5) were unchanged, except that two processes were achieved by a one-step doping process in step (4).

### Comparative Example 5

A preparation method for a single-crystal ternary cathode material in this comparative example specifically comprised the following steps: ZrO₂, Al₂O₃ and WO₃ in the steps (4) and (5) were unchanged, except that two processes were achieved by a one-step doping process in the step (4).

### Analysis on Example 1 and Comparative Examples 1-3

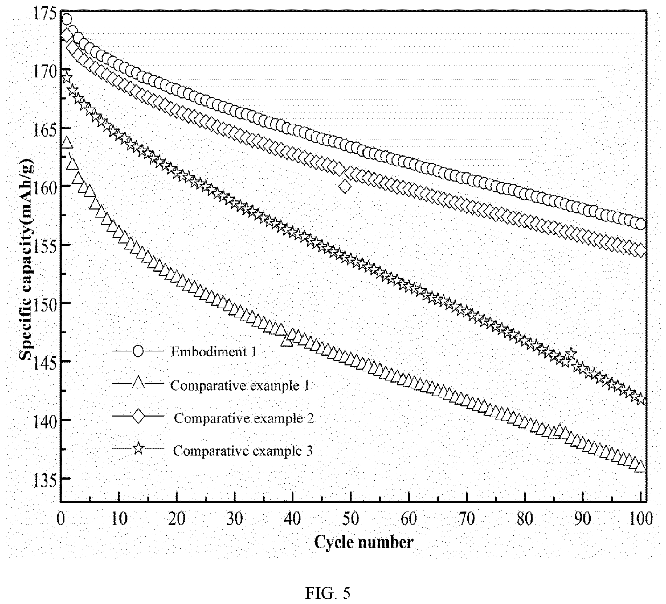

Fig. 1 shows XRD data of Example 1 and Comparative Example 1. (006)/(102) and (108)/(110) crystal face peaks are obviously separated, indicating that both of two materials have relatively high crystallization degree; and in addition, the peak intensity ratio of the (003)/(104) crystal face in XRD is more than 1.2, indicating that both of the two materials are of relatively good laminated crystal structure and are relatively small in nickel-lithium disordering. In the XRD, the peak intensity and the peak intensity ratio of (003)/(104) of Example 1 are stronger than those in Comparative Example 1, indicating that the material in Example 1 has superior crystallinity, and lower nickel-lithium disordering degree,. Meanwhile, the peak position in Example 1 is inclined left relative to that in Comparative Example 1, indicating that a layer spacing of the material is relatively large. The above results indicate that relatively high lithium proportion can improve the structure integrity of the material and the layer spacing of the material, which facilitates deintercalation and intercalation of the lithium ions, is a reason for increased lithium ion utilization rate and large diffusion coefficient, and largely affects dynamics of the material. Fig. 2 shows a single-crystal ternary cathode material prepared in Example 1. There is a protective layer on the surface of the material. Firstly, the protective layer may consume residual lithium on the surface and micro powder generated in the crushing process during the formation process, which is beneficial to improving gas production of the battery; secondly, the protective layer can supplement loss caused by lithium side reaction in a lattice under high voltage; and thirdly, the protective layer can isolate the side reaction between the electrolytic solution and the battery cathode material, so the protective layer described above can significantly improve the cycle performance and capacity of the material. Fig. 3 shows SEM graph of a single-crystal ternary cathode material prepared in Comparative Example 2. There are a little micro powder produced by crushing on the surface of the material. Fig. 4 shows SEM graph of a single-crystal ternary cathode material prepared in Comparative Example 3. When the material is doped on the high-temperature surface, the surface of the material is formed to be relatively smooth, with less micro powder, but the residual lithium on the material surface is clearly seen. Fig. 5 shows the cycle performances of materials prepared in Example 1 and Comparative Examples 1-3. From the surfaces of the materials, the material prepared in Example 1 has better cycle performance and the highest capacity. Table 1 shows first-cycle test results of button type half-cells prepared with the cathode materials in Example 1 and Comparative Examples 1-3.

**Table 1 Data of Example 1 and Comparative Examples 1-3**

| | Specific capacity of initial discharging (mAh/g) (25°C, 4.45 V/0.1 C) | Efficiency of initial charging and discharging (%) Efficiency=dischargin g capacity/charging capacity | Specific capacity after 100 cycles (mAh/g) (25°C, 4.45 V/0.1 C) | Efficiency of charging and discharging (%) |
|---|---|---|---|---|
| Example 1 | 194.7 | 89.2 | 191.3 | 88.9 |
| Comparative Example 1 | 189.6 | 87.7 | 176.9 | 85.4 |
| Comparative Example 2 | 192.5 | 88.2 | 188.5 | 87.2 |
| Comparative Example 3 | 191.2 | 87.9 | 182.7 | 86.2 |

Table 1 shows comparison of electrochemical performance of the cathode materials in Example 1 and Comparative Examples 1-3. In Example 1, the maximum voltage is 4.45 V, the specific capacity of initial discharging at 0.1 C is 194.7 mAh/g, and the efficiency of initial charging and discharging is 89.2%, which are significantly higher than the specific capacities and efficiencies of the cathode materials in comparative examples. By adding more lithium, the lithium and nickel disordering and a lattice spacing of the material are significantly improved. At the same time, doping stabilizes the crystal structure of the ternary material. In addition, a layer of more stable shell is constructed by doping of the surface layer to protect the structural stability of the internal material. Meanwhile, coating converts the unfavorable residual lithium on the surface of the single-crystal material into the favorable fast ion conductive network or lithium supplement agent. In conclusion, an energy barrier for deintercalation and intercalation of the lithium ions is reduced, and thus the initial-cycle specific capacity and efficiency of the material are improved.

The examples of the present invention are described in detail above in combination with the accompanying drawings, but the present invention is not limited to the above examples. Various changes can also be made within the knowledge of ordinary technicians in the technical field without departing from the purpose of the present invention. In addition, in the case of no conflicting, the examples of the present invention and the features in the examples can be combined with each other.

## Claims

1. A single-crystal ternary cathode material, wherein the chemical formula of the single-crystal ternary cathode material is LiNiₓCo_{y}Mn_{z}M_{(1-x-y-z)}O_{c}@LiₐN_{d}O_{b}, wherein 0<x≤0.65, 0 <y≤0.15, 0<z≤0.35, 0<a≤6, 0<b≤4, 1<c≤2 and 1≤d<2; M are at least one of Zr, Ni, Al, Cu, Co, Sr, Mn, Y, Ti, Mg, Mo, B, Sn, Fe, Zn, Si and W; and N is at least one of Zr, Ni, Al, Cu, Co, Sr, Mn, Y, Ti, Mg, Mo, B, Sn, Fe, Zn, Si and W.

2. The single-crystal ternary cathode material of claim 1, wherein the chemical formula of the single-crystal ternary cathode material is LiNi_{0.596}Co_{0.05}Mn_{0.35}M_{0.004}O_{c}@Li₂N_{d}O₄; M is at least one of Zr, Zn, Si and W; and N is at least one of Zr, Al, Mo, Zn, Si and W, wherein x=0.596, y=0.05, z=0.35, a=2, b=4, 1<c≤2, and 1≤d<2.

3. A preparation method for the single-crystal ternary cathode material of any one of claims 1-2, comprising the following steps:
(1) mixing a nickel salt, a manganese salt and a cobalt salt, adding a precipitator and a complexing agent, conducting reaction and solid-liquid separation, and taking a solid phase to obtain a precursor;
(2) mixing the precursor with a lithium source and a first doping agent for first sintering, and conducting crushing to obtain a single-crystal material; and
(3) mixing the single-crystal material with a second doping agent for second sintering, adding a coating agent for mixing, and conducting third sintering to obtain a single-crystal cathode material.

4. The preparation method of claim 3, wherein in the step (1), the nickel salt is at least one of nickel sulfate, nickel chloride and nickel nitrate; the manganese salt is at least one of manganese sulfate, manganese chloride and manganese nitrate; and the cobalt salt is at least one of cobalt sulfate, cobalt chloride and cobalt nitrate.

5. The preparation method of claim 3, wherein in the step (2), the lithium source is at least one of LiOH, Li₂CO₃, LiNO₃ and CH₃COOLi.

6. The preparation method of claim 3, wherein in the step (2), a ratio of a mole number of lithium in the lithium source to a total mole number of nickel, cobalt and manganese in the precursor is 1: (1.06-1.25).

7. The preparation method of claim 3, wherein in the step (2), the first doping agent is an oxide of at least one of the following doping elements: Zr, Ni, Al, Cu, Co, Sr, Mn, Y, Ti, Mg, Mo, B, Sn, Fe, Zn, Si or W; and the total content of the doping elements is 300-5000 ppm.

8. The preparation method of claim 3, wherein in the step (3), the second doping agent is an oxide of at least one of the following doping elements: Zr, Ni, Al, Cu, Co, Sr, Mn, Y, Ti, Mg, Mo, B, Sn, Fe, Zn, Si and W; the total content of the doping elements is 1000-10000 ppm; in the step (3), the coating agent is an oxide of at least one of the following coating elements: Zr, Ni, Al, Cu, Co, Sr, Mn, Y, Ti, Mg, Mo, B, Sn, Fe, Zn, Si and W; and the total content of the coating element is 1000-5000 ppm.

9. The preparation method of claim 3, wherein in the step (3), a process of the second sintering is performed as follows: air/oxygen having an intensity of pressure of 0.15-0.5 MPa is introduced, a temperature is raised to 650-950°C at a heating rate of 0.5-5.0°C/min for pre sintering for 3-8 h, and natural cooling is conducted to room temperature to obtain the single-crystal ternary cathode material.

10. A battery, comprising the single-crystal ternary cathode material of any one of claims 1-2.
